# EUROPÄISCHE PATENTANMELDUNG

(11) **EP 0 959 653 A2**
(43) Veröffentlichungstag der Anmeldung: **24.11.1999**
(21) Anmeldenummer: 99106824.8
(22) Anmeldetag: 06.04.1999
(51) Int. Cl.: H05K 13/00

(54) **Lagereinrichtung zum Bereithalten elektronischer Bauelemente**

(30) Priorität: 20.05.1998 DE 29809169 U
(71) Anmelder: SIEMENS AKTIENGESELLSCHAFT, 80333 München (DE)
(72) Erfinder: Rieger, Karl-Martin, 59558 Lippstadt (DE)

(57) **Zusammenfassung**

Eine Lagereinrichtung zum Bereithalten elektronischer Bauelemente mit einem gasdichten Gehäuse (12) zur Aufnahme der Bauelemente und mit einer Vorrichtung (32) zum Aufrechterhalten einer vorgegebenen Gasatmosphäre im Gehäuse (12) ist dadurch gekennzeichnet, daß die Vorrichtung zum Aufrechterhalten der Gasatmosphäre eine Entfeuchtungseinrichtung (32) zum Entfeuchten des im Gehäuse (12) befindlichen Gases hat.

## Beschreibung

Die Erfindung betrifft eine Lagereinrichtung zum Bereithalten elektronischer Bauelemente, mit einem zumindest annähernd gasdichten Gehäuse zur Aufnahme der Bauelemente, und mit einer Vorrichtung zum Aufrechterhalten einer vorgegebenen Gasatmosphäre im Gehäuse.

Elektronische Bauelemente, wie beispielsweise Widerstände, Kondensatoren, Dioden, Transistoren oder integrierte Schaltungen, können aufgrund ihres Aufbaues und der Materialien, aus denen sie gefertigt sind, hygroskopisch sein, so daß die Bauelemente Feuchtigkeit aus der Umgebungsluft aufnehmen können. Die Feuchtigkeit in den Bauelementen führt zu Qualitätsproblemen beim Auflöten der Bauelemente auf Leiterplatten. Die von den Bauelementen aufgenommene Feuchtigkeit verdampft nämlich durch das plötzliche Erhitzen beim Löten. Durch den Dampfdruck können die Bauelemente zerstört werden. Dies gilt insbesondere für Bauelemente, die sich für die SMD-Technik (SMD = Surface mounted devices) eignen, bei der die Bauelemente zunächst auf die Oberfläche der Leiterplatte geklebt und anschließend durch Schwall- oder Reflow-Löten mit dieser verlötet werden.

Um die Bauelemente vor Feuchtigkeit zu schützen, werden sie vom Hersteller in verschweißten Folienverpackungen geliefert, in denen beigefügte Silikagel-Beutel die Feuchtigkeit in den Folienverpackungen aufnehmen, um das Eindiffundieren von Feuchtigkeit in die Bauelemente zu verhindern. Für die Lagerung und Bereitstellung angebrochener Verpackungen oder einzelner Bauelemente wird von den Bauelemente-Herstellern empfohlen, die Bauelemente unter der schützenden Atmosphäre eines reinen Gases wie Stickstoff bereitzuhalten. Zu diesem Zweck ist es bekannt, Lagereinrichtungen, wie beispielsweise Lagerschränke, Regale oder Paternosterregale, mit einem zumindest annähernd gasdichten Gehäuse auszustatten, in dem die Bauelemente aufgenommen sind. Im Gehäuse wird durch eine Vorrichtung eine vorgegebene Schutzgasatmosphäre aufrechterhalten. Bei diesen bekannten Lagereinrichtungen besteht nun das Problem, daß beim Entnehmen von Bauelementen für den nachfolgenden Fertigungsprozeß Schutzgas aus dem Gehäuse der Lagereinrichtung entweicht, das anschließend ersetzt werden muß, so daß entsprechend aufwendig gestaltete Versorgungssysteme für das Schutzgas vorgesehen sein müssen.

Es ist Aufgabe der Erfindung, eine einfach aufgebaute Lagereinrichtung zum Bereithalten elektronischer Bauelemente anzugeben, bei der die Verwendung eines teuren Schutzgases entfällt.

Diese Aufgabe wird für eine Lagereinrichtung der eingangs genannten Art dadurch gelöst, daß die Vorrichtung zum Aufrechterhalten der Gasatmosphäre eine Entfeuchtungseinrichtung zum Entfeuchten des im Gehäuse befindlichen Gases hat. Vorteilhafte Weiterbildungen ergeben sich aus den Unteransprüchen.

Durch die erfindungsgemäße Lösung ist es nicht mehr erforderlich, reine Schutzgase wie Stickstoff, die herstellungsbedingt einen geringen Feuchtigkeitsgehalt besitzen, in das Innere des Gehäuses einzuleiten. Vielmehr ist die Verwendung von Umgebungsluft als Gas möglich, die, sobald sie sich im Inneren des Gehäuses der Lagereinrichtung befindet, durch die Entfeuchtungseinrichtung entfeuchtet wird. Durch den Einsatz von entfeuchteter Luft im Gehäuse sind auch aufwendige Versorgungseinrichtungen an der Lagereinrichtung für das Schutzgas entbehrlich, so daß der Aufbau der erfindungsgemäßen Lagereinrichtung verglichen mit herkömmlichen Lagereinrichtungen vereinfacht ist. Darüber hinaus wird Feuchtigkeit, die bereits von Bauelementen aufgenommen ist, an die getrocknete Luft im Gehäuse wieder abgegeben, sobald die Bauelemente in die erfindungsgemäße Lagereinrichtung gelegt werden.

Als Entfeuchtungseinrichtung eignet sich insbesondere ein Adsorptionstrockner, der verglichen mit herkömmlichen Entfeuchtungseinrichtungen wie beispielsweise Kondensationstrocknern einen hohen Wirkungsgrad besitzt. Als Adsorptions-trockner wird aufgrund seines geringen Platzbedarfes vorzugsweise ein Trocknertyp vorgeschlagen, der nach dem Rotorprinzip arbeitet. Dieser Trocknertyp hat einen angetriebenen Rotor mit mindestens einer Lage eines organischen Faservlieses, in dem Metallsilikat chemisch gebunden ist. Zum Entfeuchten der Luft bewegt sich der Rotor zunächst durch seinen aus dem Inneren des Gehäuses kommenden Luftstrom, wobei das Metallsilikat einen Teil der Feuchtigkeit der Luft aufnimmt. Anschließend bewegt sich der Rotor durch einen erwärmten Luftstrom, an dem ein Teil der vom Metallsilikat aufgenommenen Feuchtigkeit abgegeben wird.

Damit bereits von den Bauelementen aufgenommene Feuchtigkeit wieder an die feuchtigkeitsreduzierte Luft im Gehäuse abgegeben wird, sollte der Feuchtigkeitsgehalt der Luft im Inneren des Gehäuses möglichst gering sein. So sollte der Feuchtigkeitsgehalt durch die Entfeuchtungseinrichtung so stark reduziert werden, daß der Taupunkt der Luft im Inneren des Gehäuses in einem Bereich von -70 bis -100 °C liegt.

Vorzugsweise ist die Entfeuchtungseinrichtung außerhalb des Gehäuses angeordnet und steht über Leitungen mit dem Inneren des Gehäuses in Verbindung. Dadurch können gegebenenfalls auftretende Wartungs- oder Reparaturarbeiten an der Entfeuchtungseinrichtung vorgenommen werden, ohne daß das Gehäuse der Lagereinrichtung geöffnet werden muß und die feuchtigkeitsreduzierte Luft entweichen kann.

Bei einer bevorzugten Ausführungsform hat das Gehäuse eine Tür und ist zur Aufnahme mindestens eines Rüstwagens geeignet, so daß es möglich ist, den Rüstwagen mit Bauelementen vorzukommissionieren und anschließend in der Lagereinrichtung bis zu seinem Einsatz in der feuchtigkeitsreduzierten Atmosphäre aufzubewahren.

Ferner wird vorgeschlagen, am Gehäuse der Lagereinrichtung eine Schleuse vorzusehen, durch die die Bauelemente in das Gehäuse eingeschleust bzw. aus dem Gehäuse ausgeschleust werden können. Durch die Schleuse ist es möglich, kleine Stückzahlen von Bauelementen der Lagereinrichtung zu entnehmen, ohne daß die Lagereinrichtung geöffnet werden muß.

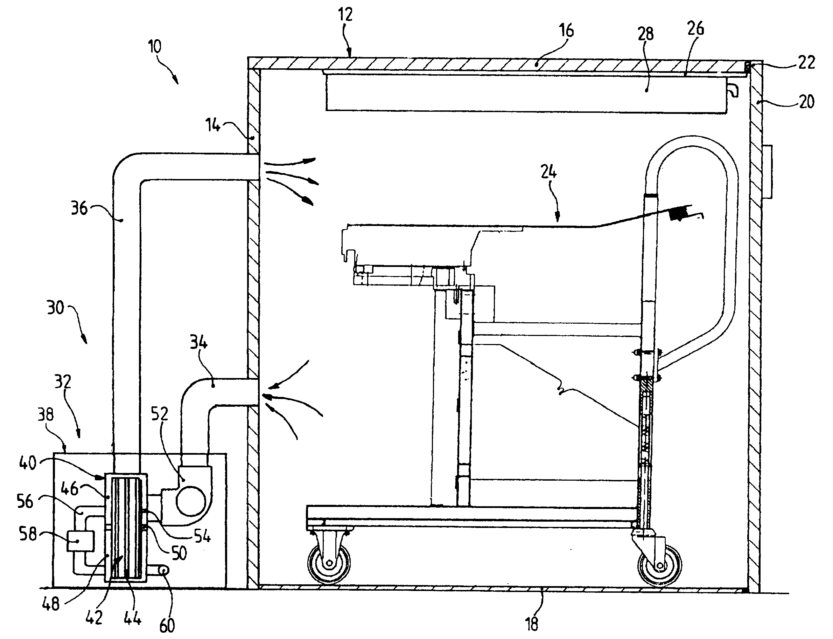

Nachfolgend wird die Erfindung anhand eines Ausführungsbeispieles unter Bezugnahme auf die Zeichnung näher erläutert. Darin zeigt die einzige Figur eine teilweise geschnittene Ansicht einer Lagereinrichtung, die zur Aufnahme eines Rüstwagens geeignet ist.

In der Figur ist in teilweise geschnittener Ansicht eine Lagereinrichtung 10 gezeigt. Die Lagereinrichtung 10 hat ein vorzugsweise aus Edelstahl gefertigtes Gehäuse 12 mit einer Rückwand 14, einer Deckplatte 16, einer Grundplatte 18 und zwei Seitenwänden (nicht dargestellt). Die Vorderwand des Gehäuses 12 bildet eine an einer der Seitenwände schwenkbar gelagerte Tür 20, die in geschlossenem Zustand unter Vorspannung an an der Deckplatte 16, an den Seitenwänden und an der Grundplatte 18 vorgesehenen Dichtungselementen 22 anliegt, so daß das Gehäuse 12 zur Umgebung hin zumindest annähernd gasdicht abgeschlossen ist. Im dargestellten Ausführungsbeispiel ist der Türrahmen des Gehäuses 12, in dem die Tür 20 gehalten ist, so groß, daß ein Rüstwagen 24, der beispielsweise mit elektronischen Bauelementen bestückt ist, im Gehäuse 12 aufgenommen werden kann. Für weitere zu lagernde Bauelemente ist zusätzlich an der Unterseite der Deckplatte 16 des Gehäuses 12 eine an Schienen 26 verschieblich gelagerte Schublade 28 vorgesehen, in der bereits angebrochene Verpackungen mit elektronischen Bauelementen sowie einzelne elektronische Bauelemente bereitgehalten werden können.

An der Rückwand 14 des Gehäuses 12 ist eine Entfeuchtungseinrichtung 30 vorgesehen. Die Entfeuchtungseinrichtung 30 hat einen Adsorptionstrockner 32, der durch ein an der Rückwand 14 vorgesehenes Ansaugrohr 34 und durch ein gleichfalls an der Rückwand 14 des Gehäuses 12 befestigtes Rückführrohr 36 mit dem Inneren des Gehäuses 12 in Verbindung steht.

Der Adsorptionstrockner 32 hat ein in einem Trocknergehäuse 38 befestigtes Rotorgehäuse 40, in dem ein angetriebener Rotor 42 drehbar gelagert ist. Der Rotor 42 hat mehrere konzentrisch zur Drehachse des Rotors 42 angeordnete Lagen 44 aus einem anorganischen Faservlies, in dem Metallsilikat chemisch gebunden ist. Das Rotorgehäuse 40 hat einen oberen Abschnitt 46 und einen unteren Abschnitt 48, die durch Trennwände 50 voneinander getrennt sind. In dem oberen Abschnitt 46 des Rotorgehäuses 40 mündet das Ansaugrohr 34, an dem ein Ansauggebläse 52 vorgesehen ist, das die zu entfeuchtende Luft aus dem Inneren des Gehäuses 12 durch das Ansaugrohr 34 in den Adsorptionstrockner 32 fördert. An der Oberseite des Rotorgehäuse 40 ist das Rückführrohr 36 befestigt, das gleichfalls mit dem oberen Abschnitt 46 in Verbindung steht, und durch das die Luft nach dem Entfeuchten wieder ins Gehäuse 12 zurückgeleitet wird. Des weiteren ist im oberen Abschnitt 46 im Bereich des Ansaugrohrs 34 eine Umlenkwand 54 angeordnet, deren Funktion später erläutert wird.

An der dem Ansaugrohr 34 abgewandten Seitenfläche des Rotorgehäuses 40 ist eine Rückführleitung 56 vorgesehen, die den oberen Abschnitt 46 des Rotorgehäuses 40 mit dessen unterem Abschnitt 48 verbindet. In der Rückführleitung 56 ist ein Erhitzer 58 angeordnet, der die durch die Rückführleitung 56 strömende Luft erhitzt, wie später noch erläutert wird. An der in der Figur rechts dargestellten Seitenfläche des Rotorgehäuses 40 ist der untere Abschnitt 48 des Rotorgehäuses 40 durch einen Abluftkanal 60 mit der Umgebung verbunden.

Ist die Lagereinrichtung 10 im Betrieb, erfaßt ein im Gehäuse 12 angeordneter Feuchtigkeitssensor (nicht dargestellt) den Feuchtigkeitsgehalt der im Inneren des Gehäuses 12 befindlichen Luft. Steigt der Feuchtigkeitsgehalt der Luft im Inneren des Gehäuses 12 über einen vorgegebenen maximal zulässigen Wert, betätigt eine Steuerung (nicht dargestellt) des Adsorptionstrockners 32 das Ansauggebläse 52 und aktiviert gleichzeitig den Antrieb des Rotors 42. Durch das aktivierte Ansauggebläse 52 wird Luft aus dem Inneren des Gehäuses 12 über das Ansaugrohr 34 in das Rotorgehäuse 40 eingesaugt, während sich gleichzeitig der Rotor 42 dreht. Durch die Umlenkwand 54 wird ein Großteil der Luft in Richtung des Rückführrohres 36 umgelenkt, wobei die Luft durch die Lagen 44 des sich drehenden Rotors 42 strömt und dabei Feuchtigkeit an das Metallsilikat abgibt. Ein kleiner Teil der in den oberen Abschnitt 46 durch das Ansaugrohr 34 einströmenden Luft wird von der Umlenkwand 54 durch den Rotor 42 geleitet und strömt in die Rückführleitung 56 ein. Die in die Rückführleitung 56 einströmende Luft wird vom Erhitzer 58 erwärmt, wodurch das Aufnahmevermögen der Luft für Wasserdampf, d.h. der maximal mögliche Sättigungsgrad der Luft mit Wasserdampf, zunimmt. Die aus dem Erhitzer 58 austretende erhitzte Luft strömt im unteren Abschnitt 48 durch den Rotor 42 in den Abluftkanal 60, aus dem sie an die Umgebung abgegeben wird. Während die aus dem Erhitzer 58 austretende erwärmte Luft durch den sich drehenden Rotor 42 strömt, nimmt sie einen Großteil der im Metallsilikat gebundenen Feuchtigkeit auf und transportiert diese über den Abluftkanal 60 an die Umgebung ab. Da während des Entfeuchtens ein Teil der im Inneren des Gehäuses 12 befindlichen Luft an die Umgebung abgegeben wird, sind am Ansaugrohr 34 kleine Öffnungen (nicht dargestellt) vorgesehen, über die in geringen Mengen Luft nachströmen kann, um die Verluste auszugleichen.

Sobald der Feuchtigkeitssensor (nicht dargestellt) erfaßt, daß der Feuchtigkeitsgehalt der Luft im Inneren des Gehäuses 12 unter dem maximal zulässigen Wert liegt, wird der Adsorptionstrockner 32 wieder abgeschaltet. Die Schwellwerte sind dabei so eingestellt, daß der Feuchtigkeitsgehalt der Luft im Inneren des Gehäuses 12 so gering ist, daß der Taupunkt der Luft in einem Bereich von -70 bis -100° C liegt.

## Patentansprüche

1. Lagereinrichtung zum Bereithalten elektronischer Bauelemente, mit einem zumindest annähernd gasdichten Gehäuse (12) zur Aufnahme der Bauelemente, und mit einer Vorrichtung (32) zum Aufrechterhalten einer vorgegebenen Gasatmosphäre im Gehäuse (12), dadurch **gekennzeichnet,** daß die Vorrichtung zum Aufrechterhalten der Gasatmosphäre eine Entfeuchtungseinrichtung (32) zum Entfeuchten des im Gehäuse (12) befindlichen Gases hat.

2. Lagereinrichtung nach Anspruch 1, dadurch **gekennzeichnet,** daß die Entfeuchtungseinrichtung ein Adsorptionstrockner (32) ist.

3. Lagereinrichtung nach Anspruch 2, dadurch **gekennzeichnet,** daß der Adsorptionstrockner (32) einen antreibbaren Rotor (42) mit mindestens einer konzentrisch zur Drehachse des Rotors (42) angeordneten Lage (44) eines anorganischen Faservlieses hat, in dem ein Metallsilikat chemisch gebunden ist, daß sich der Rotor (42) durch einen aus dem Inneren des Gehäuses (12) kommenden Luftstrom bewegt, wobei das Metallsilikat einen Teil der Feuchtigkeit der Luft aufnimmt und daß sich der Rotor (42) durch einen erwärmten Luftstrom bewegt, an den zumindest ein Teil der vom Metallsilikat aufgenommenen Feuchtigkeit abgegeben wird.

4. Lagereinrichtung nach einem der Ansprüche 1, 2 oder 3, dadurch **gekennzeichnet,** daß der Feuchtigkeitsgehalt der Luft im Inneren des Gehäuses (12) durch die Entfeuchtungseinrichtung (32) so reduziert wird, daß der Taupunkt der Luft im Inneren des Gehäuses (12) in einem Bereich von -70 bis -100 °C liegt.

5. Lagereinrichtung nach einem der Ansprüche 1 bis 4, dadurch **gekennzeichnet,** daß die Entfeuchtungseinrichtung (32) außerhalb des Gehäuses (12) angeordnet ist, über Leitungen (34, 36) mit dem Inneren des Gehäuses (12) in Verbindung steht und die Luft aus dem Inneren des Gehäuses (12) absaugt, entfeuchtet und nach dem Entfeuchten erneut dem Inneren des Gehäuses (12) zuführt.

6. Lagereinrichtung nach einem der vorhergehenden Ansprüche, dadurch **gekennzeichnet,** daß das Gehäuse (12) eine Tür (20) hat und zur Aufnahme mindestens eines Rüstwagens (24) geeignet ist.

7. Lagereinrichtung nach einem der vorhergehenden Ansprüche, dadurch **gekennzeichnet,** daß im Gehäuse (12) mindestens eine Schublade (28) zur Aufnahme von Bauelementen vorgesehen ist.

8. Lagereinrichtung nach einem der vorhergehenden Ansprüche, dadurch **gekennzeichnet,** daß am Gehäuse (12) eine Schleuse zum Ein- und Ausschleusen der Bauelemente vorgesehen ist.
